(19) Europäisches Patentamt
European Patent Office
Office européen des brevets

(11) **EP 1 695 391 B1**

(12) **EUROPÄISCHE PATENTSCHRIFT**

(45) Veröffentlichungstag und Bekanntmachung des Hinweises auf die Patenterteilung:
**14.11.2012 Patentblatt 2012/46**

(21) Anmeldenummer: **04763589.1**

(22) Anmeldetag: **29.07.2004**

(51) Int Cl.:
*H01L 31/105* (2006.01)     *G01D 5/347* (2006.01)

(86) Internationale Anmeldenummer:
**PCT/EP2004/008483**

(87) Internationale Veröffentlichungsnummer:
**WO 2005/057668 (23.06.2005 Gazette 2005/25)**

(54) **ABTASTKOPF FÜR OPTISCHE POSITIONSMESSSYSTEME**

SCANNING HEAD FOR OPTICAL POSITIONAL MEASURING SYSTEM

TETE DE BALAYAGE POUR SYSTEME DE MESURE DE POSITION OPTIQUE

(84) Benannte Vertragsstaaten:
**AT BE BG CH CY CZ DE DK EE ES FI FR GB GR HU IE IT LI LU MC NL PL PT RO SE SI SK TR**

(30) Priorität: **10.12.2003 DE 10357654**

(43) Veröffentlichungstag der Anmeldung:
**30.08.2006 Patentblatt 2006/35**

(73) Patentinhaber: **Dr. Johannes Heidenhain GmbH 83292 Traunreut (DE)**

(72) Erfinder:
• **SPECKBACHER, Peter
84558 Kirchweidach (DE)**
• **WEIDMANN, Josef
83308 Trostberg (DE)**
• **EISELE, Christopher
83374 Traunwalchen (DE)**
• **MAYER, Elmar
83365 Nussdorf (DE)**
• **BURGSCHAT, Reiner
07745 Jena (DE)**

(56) Entgegenhaltungen:
EP-A- 1 182 705     WO-A-01/84083
DE-A1- 10 118 796     DE-A1- 19 961 250
GB-A- 1 269 634     US-A1- 2002 018 220
US-A1- 2002 021 450

• **PATENT ABSTRACTS OF JAPAN Bd. 2003, Nr. 12, 5. Dezember 2003 (2003-12-05) & JP 2003 227735 A (OLYMPUS OPTICAL CO LTD), 15. August 2003 (2003-08-15) & US 2004/036017 A1 (ITO TAKESHI) 26. Februar 2004 (2004-02-26)**

**Beschreibung**

Die Erfindung betrifft einen Abtastkopf für optische Positionsmeßsysteme. Solche Abtastköpfe dienen dazu, von einem Maßstabsgitter moduliertes Licht ortsaufgelöst zu detektieren und entsprechende Signale zwecks Bestimmung der Lage des Abtastkopfes relativ zum Maßstab bereit zu stellen.

Positionsmeßsysteme spielen in der zunehmend automatisierten Welt eine immer wichtigere Rolle. Sie liefern die Grundlage für exaktes Positionieren von Antrieben in vielen Anwendungen, z.B. im Bereich der Werkzeugmaschinen. Die hier beschriebenen optischen Positionsmeßsysteme beruhen auf der Abtastung eines Maßstabes, der eine Maßverkörperung in Form eines Strichgitters aufweist. Der hierzu verwendete Abtastkopf enthält eine Lichtquelle, von der aus Licht über ein Sendegitter auf die Maßstabsteilung fällt. Dieses Licht weist nach der Wechselwirkung mit dem Sendegitter und dem Maßstabsgitter ein räumliches Intensitätsmuster auf, das im Abtastkopf mittels eines Empfangsgitters detektiert und zur Positionsbestimmung verwendet werden kann.

Hierzu ist es bereits bekannt, einen Photodetektor aus mehreren photoempfindlichen Bereichen zu bilden. Diese photoempfindlichen Bereiche werden im Abtastkopf so angeordnet, daß sie unterschiedliche Phasen des Intensitätsmusters erfassen und entsprechende elektrische Ausgangssignale liefern können. Die einzelnen, regelmäßig angeordneten photoempfindlichen Bereiche bilden dabei ein Empfangsgitter.

Vorzugsweise werden vier um jeweils 90 Grad gegeneinander versetzte Signale erzeugt, aus denen sich in einer Folgeelektronik richtungsbehaftete Zählsignale ableiten lassen. Bei einer Verschiebung des Maßstabes relativ zum Abtastkopf ändern sich nämlich die einzelnen phasenverschobenen Signale positionsabhängig.

Üblicherweise werden aus den erwähnten vier Ausgangssignalen zunächst zwei um 90 Grad gegeneinander verschobene, von Offset-, Amplituden- und Phasenfehlern befreite Signale synthetisiert, die sich für eine feinere Unterteilung bzw. Interpolation eignen. Die richtungsbehafteten Zählsignale können damit eine wesentlich feinere Positionsfeststellung erlauben als es z.B. durch das Zählen der Maxima und / oder Minima des Intensitätsmusters an den photoempfindlichen Bereichen des Abtastkopfes möglich wäre.

Aus weiter unten geschilderten Gründen ist es vorteilhaft, wenn die einzelnen photoempfindlichen Bereiche möglichst nahe beieinander liegen. Der Einsatz von diskreten Bauteilen wie Photodioden begrenzt hier die mögliche Miniaturisierung der Photodetektoren. Es wurden daher bereits strukturierte Photodetektoren realisiert, die mit herkömmlichen Prozeßschritten aus der Mikroelektronik die Herstellung strukturierter, photoempfindlicher Bereiche auf einem einzigen Halbleitersubstrat erlauben.

Wegen der geringen Neigung zum Übersprechen zwischen den einzelnen photoempfindlichen Bereichen bietet sich dabei vor allem das technologisch gut beherrschbare amorphe Silizium (a-Si) an, dessen Einsatz zur Wandlung von Licht in elektrischen Strom z.B. aus dem Bereich der Solarzellen bekannt ist.

Die US 2002/0021450 A1 beschreibt einen Sensor zum feststellen der Position eines Lichtpunktes. Hier werden p-i-n Halbleiterschichtstapel aus amorphem Silizium beschrieben, die eine gemeinsame p-Schicht aufweisen.

Die GB 1269634 A beschreibt eine Kamera für Gammastrahlung, mit der einzelne Photonen ortsaufgelöst festgestellt werden können. Hierbei kommt ein Halbleiterschichtstapel zum Einsatz, dessen außen liegende, dotierte Bereiche gitterartig und zueinander senkrecht durch geätzt sind.

Für Positionsmessgeräte der hier behandelten Art sind diese beiden Sensoren nicht geeignet, da sich keine gegeneinander phasenverschobene, positionsabhängige Signale ableiten lassen.

Die DE 19961250 A1 liefert ein Beispiel für einen dazu geeigneten Sensor, von dem sich mehrere um jeweils 90 Grad gegeneinander verschobene Signale abgreifen lassen.

Die DE 10129334 A1 beschreibt ein optisches Positionsmeßsystem mit einer Lichtempfangsanordnung basierend auf dem oben beschriebenen Prinzip. Die photoempfindlichen Bereiche zum Abtasten von örtlich intensitätsmoduliertem Licht unterschiedlicher Phasenlage sind als Empfangsgitter in Form mehrerer Halbleiterschichtstapel aus dotiertem und undotiertem amorphen Silizium aufgebaut. Der Aufbau des strukturierten Detektors ist jedoch sehr komplex, so daß auch das Verfahren zu seiner Herstellung aufwändig ist.

Aufgabe der Erfindung ist es, einen gegenüber dem Stand der Technik vereinfachten Abtastkopf für ein optisches Positionsmeßgerät zu schaffen, der möglichst gute Signale zur Positionsbestimmung liefert.

Diese Aufgabe wird gelöst durch eine Vorrichtung mit den Merkmalen des Anspruches 1. Vorteilhafte Ausführungsformen ergeben sich aus den Merkmalen, die in den von Anspruch 1 abhängigen Ansprüchen aufgeführt sind.

Es wird ein Abtastkopf für ein optisches Positionsmeßsystem beschrieben, mit einem aus photoempfindlichen Bereichen gebildeten Empfangsgitter zum Abtasten von örtlich intensitätsmoduliertem Licht unterschiedlicher Phasenlage. Das Empfangsgitter ist aus einem Halbleiterschichtstapel, bestehend aus einer dotierten p-Schicht, einer intrinsischen i-Schicht und einer dotierten n-Schicht gebildet. Die einzelnen photoempfindlichen Bereiche haben eine erste dotierte Schicht und zumindest einen Teil intrinsischen Schicht gemeinsam und sind durch Unterbrechungen der zweiten dotierten Schicht elektrisch voneinander getrennt.

Es wurde nämlich einerseits erkannt, daß bereits die Trennung lediglich einer der dotierten Schichten zu einer ausreichenden elektrischen Trennung der einzelnen photoempfindlichen Bereiche führt. Ein für die Zwecke der Positionsbestimmung nachteiliges Übersprechen zwischen Bereichen unterschiedlicher Phasenlage tritt schon bei sehr geringen Abständen der einzelnen Bereiche zueinander nicht mehr auf.

Andererseits vermeidet ein solcher Schichtaufbau auch ein anderes, im Stand der Technik beschriebenes Problem. Trennt man nämlich die photoempfindlichen Bereiche auch durch Auftrennen der intrinsischen Schicht (und evtl. auch der zweiten dotierten Schicht), so bilden sich tiefe Gräben, die sich ätztechnisch nur schwer beherrschen lassen. Ätzdefekte im Bereich der intrinsischen Schicht können außerdem für Störstellen im Halbleitermaterial sorgen, wodurch die photoelektrischen Eigenschaften der einzelnen photoempfindlichen Bereiche sehr negativ beeinflußt werden.

Als Halbleitermaterial eignet sich besonders gut amorphes Silizium, es sind aber auch Halbleiterschichtstapel denkbar, die ganz oder teilweise mikrokristallines Silizium enthalten.

Weitere Merkmale wie die Anordnung des Sendegitters im Flächenschwerpunkt des Empfangsgitters, eine annährend elliptische oder ovale Form des Empfangsgitters, das senkrecht zur Meßrichtung eine größere Ausdehnung hat als parallel dazu, sowie die Gewinnung von phasenverschobenen Signalen aus jeweils einer einzigen Periode des modulierten Lichtes am Empfangsgitter führen zu einer Optimierung der gewonnenen Abtastsignale und damit zu einer verbesserten Interpolationsfähigkeit und so letztlich zu einer höheren Auflösung des optischen Positionsmeßsystems.

Der Aufbau des Abtastkopfes, und insbesondere des Empfangsgitters mit seinen photoempfindlichen Bereichen, erlaubt auf sehr elegante Weise solche Optimierungen im Layout des strukturierten Detektors.

Weitere Vorteile sowie Einzelheiten der vorliegenden Erfindung ergeben sich aus der nachfolgenden Beschreibung bevorzugter Ausführungsformen anhand der Figuren. Dabei zeigen die

Figuren 1a/b/c      ein optisches Positionsmeßgerät,

Figuren 2a/b/c/d/e      Ausgestaltungen eines Zweifeldsensors, und

Figuren 3a/b/c/d      Ausgestaltungen eines Einfeldsensors.

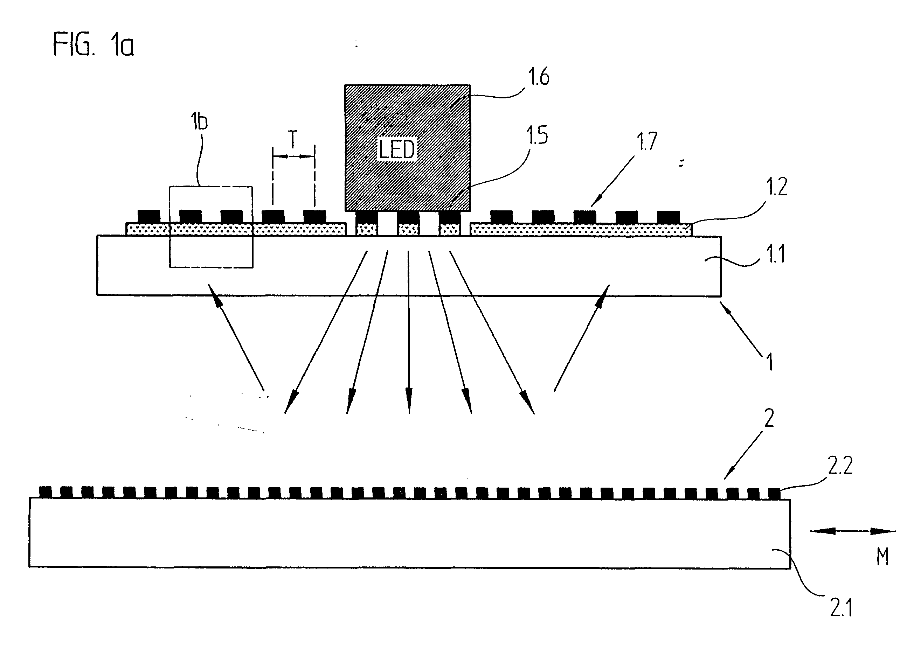

Figur 1a zeigt einen Maßstab 2, der auf einem Substrat 2.1 ein optisches Gitter trägt, das hier auch als Maßstabsteilung 2.2 bezeichnet werden soll. Eine solche Maßstabsteilung 2.2 kann beispielsweise als Amplitudengitter mit lichtundurchlässigen Stegen aus Chrom und lichtdurchlässigen Lücken in der Chrombeschichtung bestehen. Dabei kann das Substrat 2.1 lichtdurchlässig, oder wie im dargestellten Fall, reflektierend ausgebildet sein. Andere Maßstäbe 2 können auch ein Phasengitter oder eine Kombination aus Phasen- und Amplitudengittern aufweisen.

Dem Maßstab gegenüber angeordnet ist ein Abtastkopf 1. Der Abtastkopf 1 enthält eine Lichtquelle 1.6, deren Licht über ein Sendegitter 1.5 auf den Maßstab 2 fällt, dort reflektiert und zum Abtastkopf 1 zurückgelenkt wird. Nach der Wechselwirkung mit dem Sendegitter 1.5 und der Maßstabsteilung 2.2 weist das Licht ein örtliches Intensitätsmuster mit regelmäßiger Periode auf. Dieses Intensitätsmuster wird mittels eines Empfangsgitters 1.7 mit einer Teilungsperiode T detektiert. Dabei dient das Empfangsgitter 1.7 selbst als strukturierter Photodetektor zur Detektion des Intensitätsmusters.

Das Empfangsgitter 1.7 weist nämlich einen strukturierten Halbleiterschichtstapel 1.2 auf, der einfallendes Licht in elektrischen Strom umwandelt. Dabei wird um so mehr Strom erzeugt, desto mehr Licht auf den Halbleiterschichtstapel 1.2 fällt.

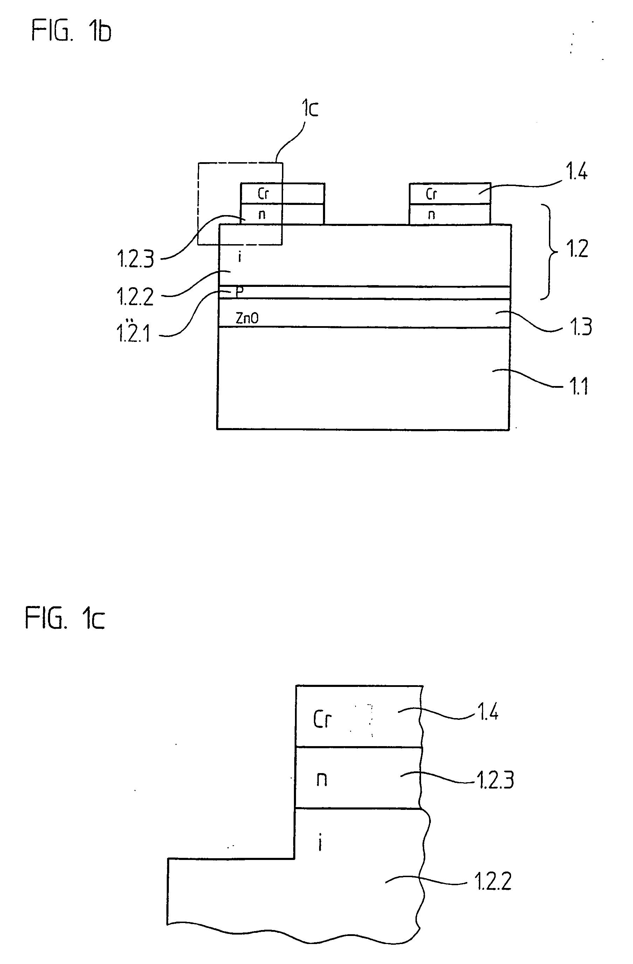

Figur 1b zeigt einen vergrößerten Ausschnitt der Figur 1 a. Man erkennt das Substrat 1.1, auf dem eine durchsichtige Elektrode 1.3 angeordnet ist, die wiederum den Halbleiterschichtstapel 1.2 trägt. Dieser weist - in der Reihenfolge des Lichtdurchganges - eine erste dotierte (hier p-dotierte), Schicht 1.2.1 (p-Schicht), dann eine intrinsische Schicht 1.2.2 (i-Schicht), und schließlich eine zweite dotierte (hier n-dotierte) Schicht 1.2.3 (n-Schicht) auf. Der n-Schicht 1.2.3 folgt ein elektrischer Rückseitenkontakt 1.4. Prinzipiell ließen sich die p-Schicht 1.2.1 und die n-Schicht vertauschen, bevorzugt ist jedoch der in der Figur 1b gezeigte Aufbau.

Die das Empfangsgitter 1.7 bildenden photoempfindlichen Bereiche sind voneinander dadurch getrennt, daß die n-Schicht 1.2.3 zusammen mit den Rückseitenkontakten 1.4 dort unterbrochen sind, wo eine Trennung der einzelnen photoempfindlichen Bereiche zur Detektion des Intensitätsmusters vorgesehen ist. Nur im Bereich der Rückseitenkontakte 1.4 wird im Halbleiterschichtstapel 1.2 bei Beleuchtung Strom erzeugt, die Rückseitenkontaktierung 1.4 definiert daher das Empfangsgitter 1.7.

Wie in der Figur 1b zu erkennen ist, kann die Strukturierung der Rückseitenkontaktierung 1.4 und der n-Schicht 1.2.3 in einem einzigen Lithographieschritt und je einem Ätzschritt für die Rückseitenkontakte 1.4 und den Halbleiterschichtstapel 1.2 erfolgen. Als Ätzverfahren für den Halbleiterschichtstapel 1.2 kommen dabei Naßätzverfahren (z.B. KOH-Lösung), bevorzugt aber Trockenätzverfahren (z.B. RIE mit $CHF_3$-Gas) in Frage. Solche Verfahren sind in der Mikroelektronik weit verbreitet und stehen daher problemlos zur Verfügung.

Figur 1c, eine weitere Ausschnittsvergrößerung der Figur 1b, zeigt ein Detail des Halbleiterschichtstapels 1.2. Um sicher zu gehen, daß die n-Schicht 1.2.3 vollständig unterbrochen wird (dies ist eine absolut notwendige Anforderung, um die einzelnen photoempfindlichen Bereich zu trennen), ist es notwendig, den Ätzprozeß so einzustellen, daß zumindest ein kleiner Teil der i-Schicht 1.2.2 ebenfalls entfernt wird. Andererseits muß zumindest ein kleiner Teil der i-Schicht 1.2.2 stehen bleiben, um sicher eine elektrische Verbindung zwischen der p-Schicht 1.2.1 und der n-Schicht 1.2.3 zu verhindern.

Der Schichtaufbau im Bereich des Empfangsgitters 1.7 könnte also z.B. wie folgt aussehen: Auf einem Glassubstrat 1.1 von ca. einem Millimeter Dicke ist eine 0.3 - 1 μm dicke Schicht von ZnO:Al aufgetragen, die sich gut als durchsichtige Elektrode 1.3 eignet. Es folgt der Halbleiterschichtstapel 1.2 mit einer p-Schicht 1.2.1 von ca. 10 nm, einer i-Schicht 1.2.2 von ca. 400nm und einer n-Schicht 1.2.3 von ca. 20 nm Dicke. Die Rückseitenkontakte 1.4 bestehen aus einer ca. 80nm dicken metallischen Schicht, beispielsweise aus Chrom oder Aluminium. Diese metallische Schicht ist gemeinsam mit der n-Schicht 1.2.3 an geeigneten Stellen zur Trennung der einzelnen photoempfindlichen Bereiche vollständig entfernt.

Durch den zur Trennung der photoempfindlichen Bereiche angewandten Ätzprozeß wird auch die i-Schicht 1.2.2 um ca. 40 nm abgetragen, um eine möglichst sichere Trennung der n-Schichten 1.2.3 zu erzielen. Dies ist notwendig, da die einzelnen Schichten nicht völlig homogen bezüglich ihrer Dicke sind, und es außerdem keinen scharf begrenzten Übergang im Dotierprofil des Halbleiterstapels 1.2 gibt, insbesondere zwischen der i-Schicht 1.2.2 und der n-Schicht 1.2.3. Es ist in diesem Zusammenhang zu erwarten, daß zwischen den photoempfindlichen Bereichen 3 eine Restdicke von 5% - 95%, besser 10%-90% der ursprünglichen Dicke der i-Schicht 1.2.2 zu guten Ergebnissen führt. Da kürzere Ätzzeiten aus fertigungstechnischer Sicht zu bevorzugen sind, und bei größerer Restdicke der i-Schicht 1.2.2 Probleme mit Defekten am freigelegten Rand der i-Schicht 1.2.2 vermieden werden, sind von den angegeben Bereichen jeweils eher die Obergrenzen (also ca. 95% bzw. ca. 90%) zu bevorzugen. Für die genannte Schichtdicke von 400nm innerhalb der photoempfindlichen Bereiche 3 wird also eine Restdicke von ca. 360nm für die i-Schicht 1.2.2 als optimal angesehen.

Es soll nun betrachtet werden, in welchem Abstand die einzelnen photoempfindlichen Bereiche angeordnet werden können, um die gewünschten phasenverschobenen Signale zu erhalten. Dieser Abstand entspricht der Teilungsperiode T des Empfangsgitters 1.7. Die Periode des Intensitätsmusters des auf das Empfangsgitter 1.7 eingestrahlten Lichtes sei P. In Abtastköpfen 1 mit als Empfangsgitter 1.7 ausgebildeten photoempfindlichen Bereichen muß wegen der Gefahr des Übersprechens zwischen den photoempfindlichen Bereichen die Teilungsperiode T größer als die Periode P gewählt werden. Werden vier um 90 Grad phasenverschobene Signale gewünscht, so muß hier gelten

$$T = (2 * n - 1) * 1/4 * P$$

(n ist eine ganze Zahl größer oder gleich drei).

Für eine Periode P = 40 μm des Intensitätsmusters des eingestrahlten Lichtes ergibt sich so eine Teilungsperiode T von mindestens 50 μm. Die einzelnen phasenverschobenen Signale werden daher aus vier unterschiedlichen Perioden des Intensitätsmusters gewonnen - und damit auch aus unterschiedlichen Bereichen der Maßstabteilung 2.2. Diese Art von strukturiertem Detektor sei daher als Vierfeldsensor bezeichnet. Dieser hat den Nachteil, daß sich Verschmutzungen auf dem Maßstab auf phasenverschobene Signale nicht gleichzeitig, sondern in der Phase versetzt auswirken. Dies hat Ungenauigkeiten bei der Auswertung der phasenverschobenen Signale zur Folge.

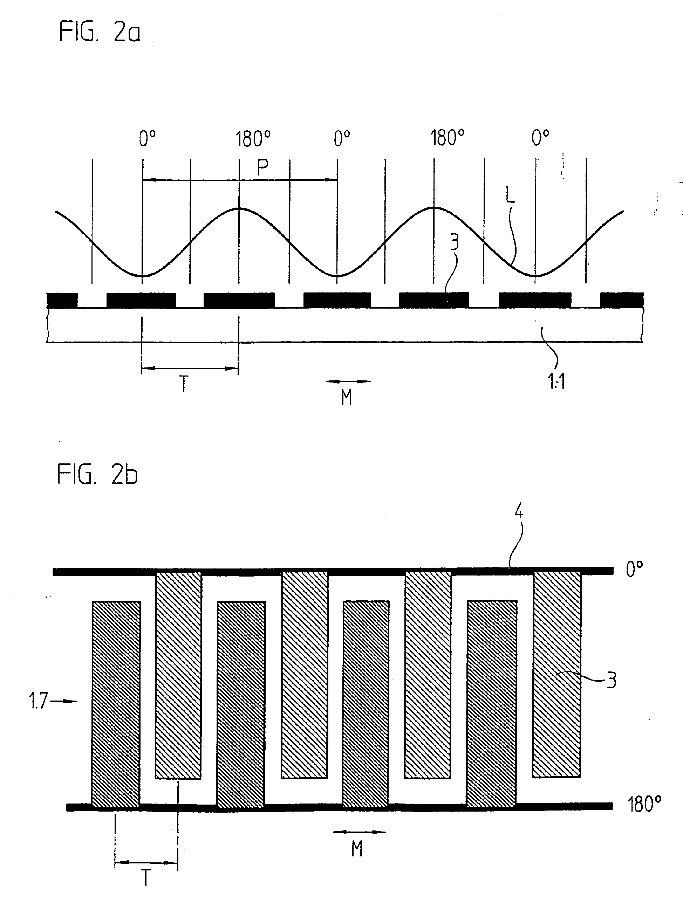

Es ist daher besser, phasenverschobene Signale innerhalb einer Periode P des Intensitätsmusters am Empfangsgitter 1.7 abzutasten. Eine Möglichkeit hierzu stellt der Zweifeldsensor dar, der in den Figuren 2a - 2e dargestellt ist.

In Figur 2a sind schematisch die photoempfindlichen Bereiche 3 zu erkennen, deren Aufbau anhand der Figuren 1a - 1c bereits ausführlich dargestellt wurde. Diese photoempfindlichen Bereiche sind auf dem Substrat 1.1 angeordnet. Das Intensitätsmuster L mit der Periode P ist schematisch dargestellt, ebenso die Meßrichtung M. Man erkennt, daß nun innerhalb einer Periode P sowohl ein 0-Grad Signal als auch ein 180-Grad Signal abgegriffen werden. Benachbarte photoempfindliche Bereiche liefern 180 Grad phasenverschobene Signale, wenn die Teilungsperiode T des Empfangsgitters 1.7 der Hälfte der Periode P des einfallenden örtlich modulierten Intensitätsmusters L entspricht.

Es gilt

$$T = 1/2 * P.$$

Verschmutzungen auf dem Maßstab 2 werden sich somit auf beide phasenverschobenen Signale auswirken.

Figur 2b zeigt, wie die photoempfindlichen Bereiche 3 durch Leiterbahnen 4 miteinander verbunden werden können, um mehrere 0-Grad Signale und mehrere 180-Grad Signale zu einem stärkeren Ausgangssignal zu vereinigen. Dabei entsteht jeweils eine Kammstruktur. Diese Kammstrukturen greifen ineinander ein, so daß sich jeweils photoempfindliche Bereiche 3 für 0-Grad Signale und photoempfindliche Bereiche 3 für 180-Grad Signale abwechseln. Wie man in Figur 2b erkennen kann, läßt sich eine solche Struktur ohne überkreuzte Leiterbahnen 4 herstellen.

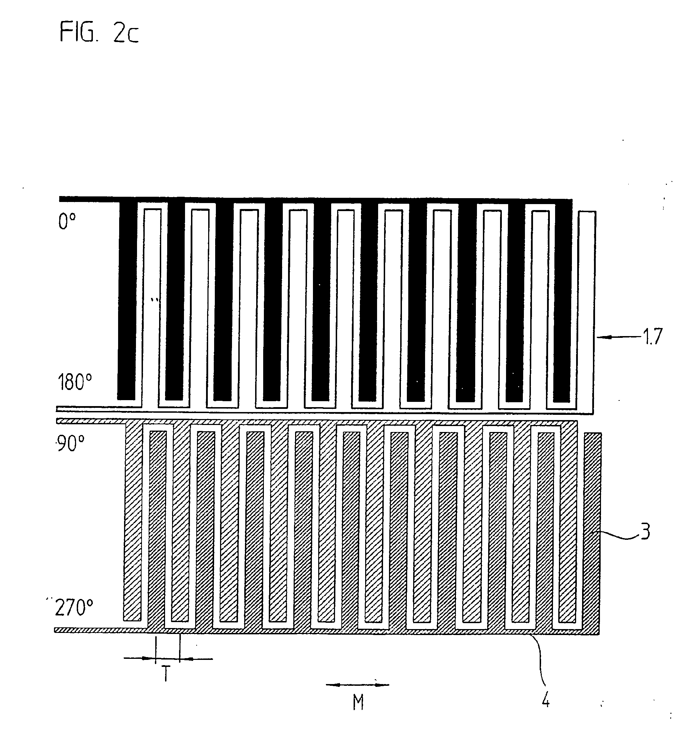

Figur 2c zeigt, wie mittels vier Kammstrukturen, von denen jeweils zwei entsprechend Figur 2b verzahnt sind, vier um jeweils 90-Grad phasenverschobene Signale gewinnen lassen. Da jedoch zwei unterschiedliche Bereiche des Intensitätsmusters am Empfangsgitter 1.7 abgetastet werden, soll hier von einem Zweifeldsensor gesprochen werden.

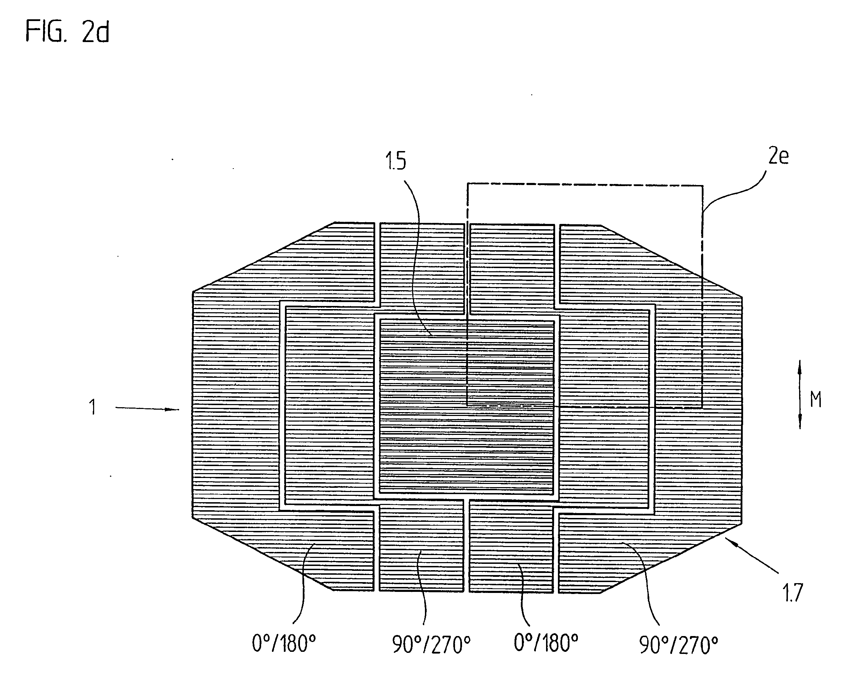

Figur 2d zeigt eine besonders vorteilhafte Ausgestaltung eines solchen Abtastkopfes 1 mit Zweifeldsensor. Im Zentrum des Zweifeldsensors ist das Sendegitter 1.5 angeordnet. Unter "Zentrum" sei der Flächenschwerpunkt des Empfangsgitters 1.7 zu verstehen. Das quadratische Sendegitter 1.5 ist dabei vollständig vom Empfangsgitter 1.7 umgeben, um das Intensitätsmuster L möglichst gut auszunützen. Die Gitterstriche von Sendegitter 1.5 und Empfangsgitter 1.7 stehen senkrecht auf der Meßrichtung M. Das Empfangsgitter 1.4 ist in vier Bereiche aufgeteilt. Von den beiden inneren Bereichen, die unmittelbar an das Sendegitter 1.5 grenzen, dient einer der Gewinnung von 0-Grad / 180-Grad Signalen, das andere der beiden der Gewinnung von 90-Grad / 270-Grad Signalen. An den inneren 0-Grad / 180-Grad Bereich grenzt vom Sendegitter 1.5 abgewandt ein weiterer 90-Grad /270-Grad Bereich. An den inneren 90-Grad / 270-Grad Bereich grenzt vom Sendegitter 1.5 abgewandt ein weiterer 0-Grad / 180-Grad Bereich. Diese zur Meßrichtung antisymmetrische Anordnung stellt sicher, daß die vier phasenverschobenen Signale mit vergleichbarer Intensität aufgenommen werden.

Die äußere Form des gesamten Empfangsgitters 1.7, das sich aus den erwähnten vier Bereichen zusammensetzt, ist als Rechteck mit abgeschrägten Ecken einem Oval bzw. einer Ellipse angenähert, deren größerer Durchmesser senkrecht zur Meßrichtung M liegt. Eine solche Form erlaubt eine besonders gute Ausnutzung des Intensitätsmusters L am Empfangsgitter 1.7.

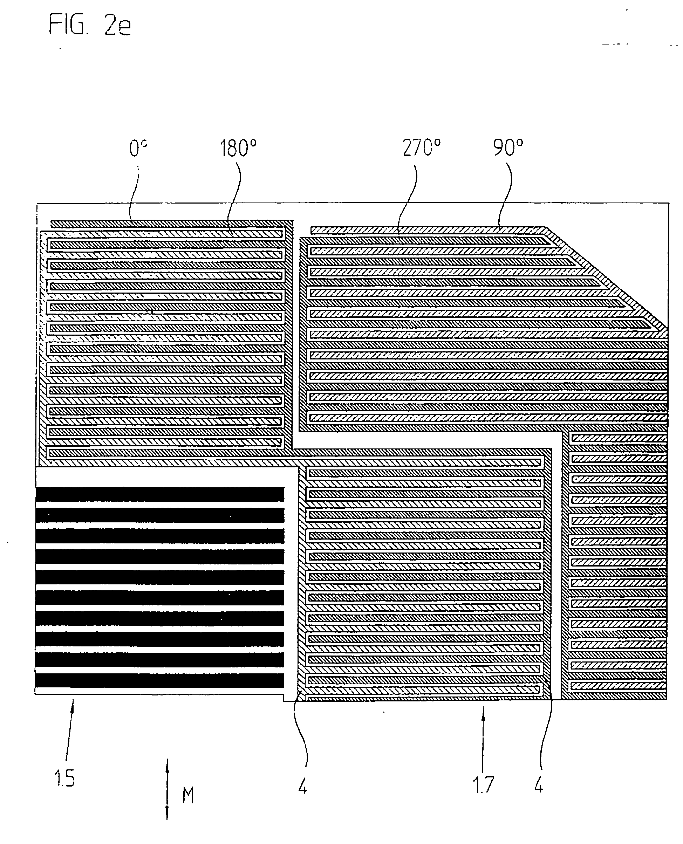

Die vier unterschiedlichen Bereiche des Empfangsgitters 1.7 nach Figur 2d sind durch verzahnte Kammstrukturen gemäß Figur 2c aufgebaut. Eine Ausschnittsvergrößerung der Figur 2d in Figur 2e macht dies deutlich. Auch dieser Zweifeldsensor, der sich in der Praxis als sehr tauglich erwiesen hat, läßt sich daher ohne überkreuzte Leiterbahnen herstellen, was den Herstellungsprozeß einfach hält: Es ist lediglich eine einzige Metallisierungsebene nötig. Mit deren Strukturierung werden gleichzeitig die photoempfindlichen Bereiche 3 definiert.

Der beschriebene Zweifeldsensor hat den Vorteil, daß die Amplituden der 0-Grad / 180-Grad Signale, bzw. die Amplituden der 90-Grad / 270-Grad Signale von etwaigen Verschmutzungen gleichzeitig und damit phasenrichtig betroffen sind. Der Tastverhältnisfehler wird dadurch reduziert und die Genauigkeit der Positionsbestimmung gegenüber einem Vierfeldsensor erhöht. Es gilt jedoch nicht, daß alle Amplituden der vier phasenverschobenen Signale phasenrichtig von Verschmutzungen beeinträchtigt werden, so daß die Abtastung weiter verbessert werden kann.

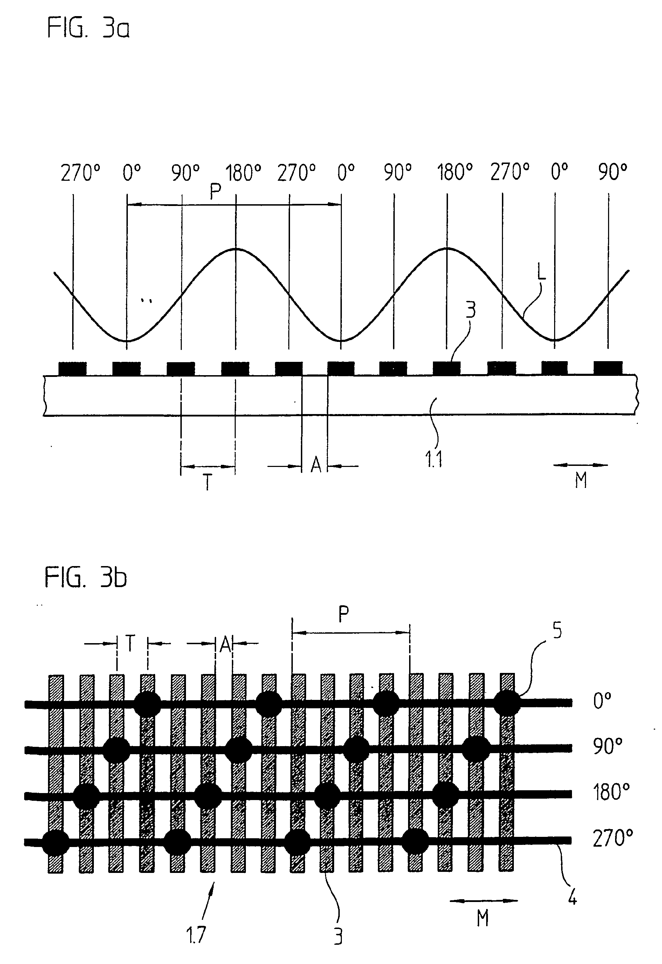

Weiter optimierte Signale erhält man von einem hier als Einfeldsensor bezeichneten Abtastkopf 1. In Figur 3a ist dargestellt, daß in einem solchen Einfeldsensor jeweils vier phasenverschobene Signale aus einer einzigen Periode P des Intensitätsmusters L gewonnen werden. Benachbarte photoempfindliche Bereiche liefern 90 Grad phasenverschobene Signale, wenn die Teilungsperiode T des Empfangsgitters 1.7 einem Viertel der Periode P des einfallenden örtlich modulierten Intensitätsmusters L entspricht. Es gilt

$$T = 1/4 * P.$$

Aus der Ansicht in Figur 3b kann man erkennen, daß ein solcher Einfeldsensor nicht mehr ohne gekreuzte Leiterbahnen auskommt. Die photoempfindlichen Bereiche 3 tragen ja auf ihrer Rückseite einen Rückseitenkontakt 1.4, der nur an bestimmten Stellen an die Leiterbahnen 4 mittels Kontaktierungen 5 angeschlossen werden darf. Zwischen den photoempfindlichen Bereichen 3 und den Leiterbahnen 4 muß also eine Isolationsschicht eingebracht werden, die nur bei den Kontaktierungen 5 unterbrochen ist. Die Kontaktierung 5 wird dann einfach dadurch gebildet, daß bei der Abscheidung der die Leiterbahnen 4 bildenden Metallschicht die Leiterbahnen 4 direkt in Kontakt mit den Rückseitenkontakten 1.4 kommen.

Es hat sich gezeigt, daß für einen Halbleiterschichtstapel 1.2 mit dem hier beschriebenen Aufbau ein Abstand A von 5 µm sicher ausreicht, um ein Übersprechen zwischen den einzelnen photoempfindlichen Bereichen 3 zu vermeiden. Je nach Detektorgeometrie und Halbeleitermaterial können aber auch noch kleinere Abstände A im µm-Bereich zu funktionsfähigen Abtastköpfen 1 führen. Der minimale Abstand A ist im Wesentlichen bestimmt durch die Diffusionslänge der Ladungsträger in der i-Schicht 1.2.2. Je geringer diese Diffusionslänge ist, desto kleiner kann der Abstand A sein. Nimmt man für intrinsisches amorphes Silizium eine Diffusionslänge von 50nm an, so sollte mit einem Abstand A von ca. 200nm kein Übersprechen mehr auftreten. Da aber aus prozeßtechnischen Gründen (zunehmender Aufwand und steigende Defektempfindlichkeit für kleinere Strukturen) größere Abstände A zu bevorzugen sind, kann man als sinnvolle Untergrenze für den Abstand A ca. 1 µm angeben.

Für eine Periode P = 40 µm des intensitätsmodulierten Lichtes ergibt sich für den Vierfeldsensor eine Teilungsperiode T des Empfangsgitters 1.7 von 10 µm. Bei einem Abstand A = 5 µm sind also die photoempfindlichen Bereiche 3 selbst nur noch 5 µm breit.

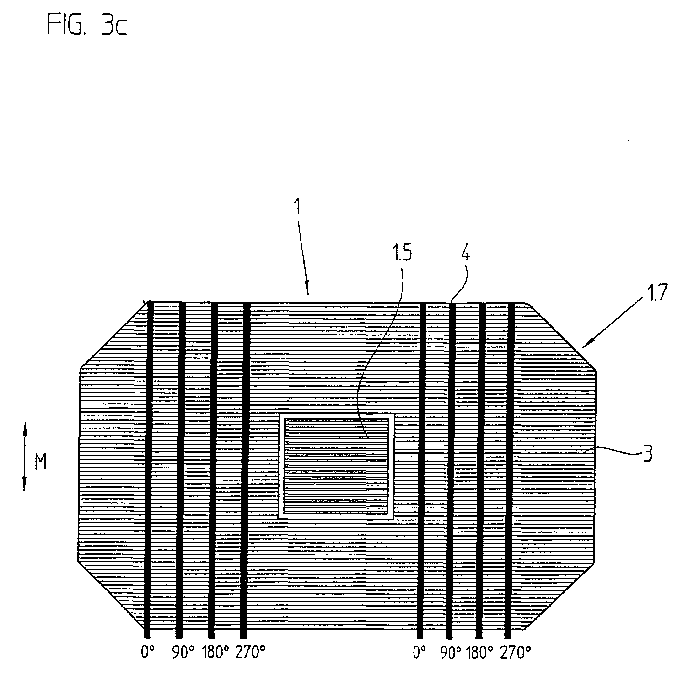

Figur 3c zeigt eine konkrete Ausführungsform eines solchen Einfeldsensors. Wieder ist im Zentrum bzw. Flächenschwerpunkt des Empfangsgitters 1.7 ein Sendegitter 1.5 angeordnet. Das Empfangsgitter 1.7, dessen Strichrichtung wie die des Sendegitters 1.5 wieder senkrecht zur Meßrichtung M verläuft, hat eine einer Ellipse angenäherte äußere Form, deren größerer Durchmesser senkrecht zur Meßrichtung M liegt. Nach Art der Figur 3b ist das Empfangsgitter 1.7 mit quer über dem Empfangsgitter 1. 7 liegenden Leiterbahnen 4 angeschlossen. Je vier solcher Leiterbahnen 4 sind beiderseits des Sendegitters 1.5 angeordnet, um so auch die durch das Sendegitter 1.5 unterbrochenen photoempfindlichen Bereiche 3 vollständig kontaktieren zu können.

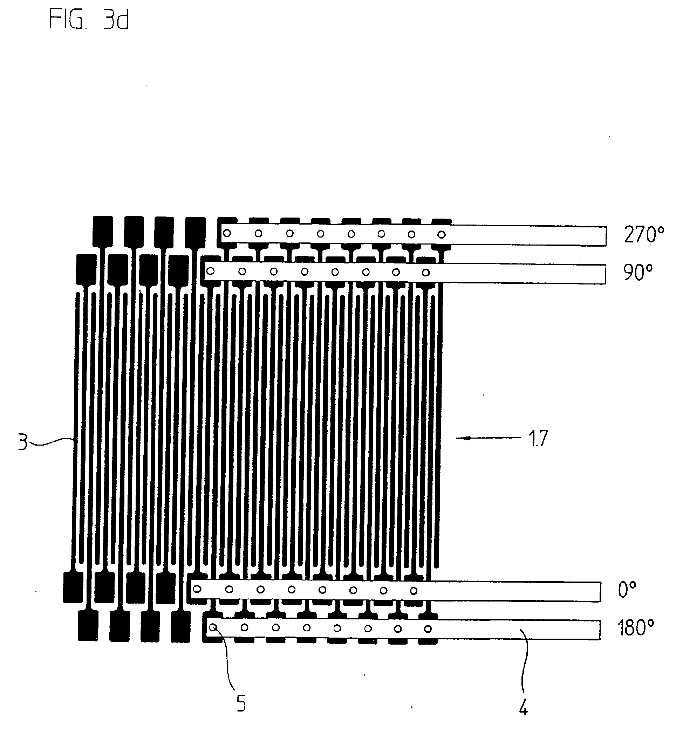

Eine alternative, und besonders für kleine Teilungsperioden T des Empfangsgitters 1.7 des Einfeldsensors zu empfehlende Variante der Kontaktierung der photoempfindlichen Bereiche 3 zeigt Figur 3d. Am Rand des Empfangsgitters 1.7 sind die Gitterlinien mit Verdickungen versehen. Da jede zweite Gitterlinie verlängert ist, lassen sich diese Verdickungen etwa doppelt so breit ausführen wie die Gitterlinien selbst. Dies erleichtert das Kontaktieren der photoempfindlichen Bereiche 3 mit den Leiterbahnen 4 über Kontaktierungen 5 erheblich. Wieder ist zu erkennen, daß sich ein solcher Einfeldsensor nicht ohne überkreuzte Leiterbahnen 4 herstellen läßt.

Es sei noch erwähnt, daß das Sendegitter 1.5 bevorzugt den gleichen Schichtaufbau wie die photoempfindlichen Bereiche 3 aufweist. Da für das Sendegitter 1.5 möglichst scharf definierte Kanten erwünscht sind, wird der Halbleiterschichtstapel 1.2 in diesem Bereich vollständig durchgeätzt. Es ist aber auch möglich, das Sendegitter 1.5 in herkömmlicher Weise lediglich als strukturierte Metallschicht unmittelbar auf dem Substrat 1.1 auszubilden. In beiden Fällen ist es möglich, die Strukturierung des Sendegitters 1.5 und der photoempfindlichen Bereiche 3 mit dem gleichen Lithographieschritt vorzunehmen.

## Patentansprüche

1.  Abtastkopf für optische Positionsmeßsysteme, mit einem Empfangsgitter (1.7) mit photoempfindlichen Bereichen (3) zum Abtasten von örtlich und periodisch intensitätsmoduliertem Licht unterschiedlicher Phasenlage, wobei die photoempfindlichen Bereiche so angeordnet sind, dass sie unterschiedliche Phasen des intensitätsmodulierten Lichts erfassen und entsprechende Ausgangssignale liefern, und wobei das Empfangsgitter (1.7) einen Halbleiterschichtstapel (1.2) aus einer dotierten p-Schicht (1.2.1), einer intrinsischen i-Schicht (1.2.2) und einer dotierten n-Schicht (1.2.3) aufweist, **dadurch gekennzeichnet, daß** die photoempfindlichen Bereiche (3) eine erste der beiden dotierten Schichten (1.2.1) und zumindest einen Teil der intrinsischen Schicht (1.2.2) gemeinsam haben und durch Unterbrechungen einer zweiten der beiden dotierten Schichten (1.2.3) elektrisch voneinander getrennt sind.

2.  Abtastkopf nach Anspruch 1, **dadurch gekennzeichnet, daß** der Halbleiterschichtstapel (1.2) auf einem durchsichtigen Substrat (1.1) mit einer leitfähigen, ebenfalls durchsichtigen Elektrode (1.3) angeordnet ist, gefolgt von Rückseitenkontakten (1.4), so daß sich ein Schichtaufbau gemäß

    - durchsichtiges Substrat (1.1)
    - leitfähige Elektrode (1.3)
    - erste dotierte Schicht oder p-Schicht (1.2.1)
    - intrinsische Schicht (1.2.2)
    - zweite dotierte Schicht oder n-Schicht (1.2.3)
    - Rückseitenkontakt (1.4)

    ergibt.

3.  Abtastkopf nach Anspruch 2, **dadurch gekennzeichnet, daß** die photoempfindlichen Bereiche (3) durch die Rückseitenkontakte (1.4) definiert sind.

4.  Abtastkopf nach Anspruch 2 oder 3, **dadurch gekennzeichnet, daß** auf dem Substrat (1.1) ein Sendegitter (1.5) angeordnet ist.

5.  Abtastkopf nach Anspruch 4, **dadurch gekennzeichnet, daß** das Sendegitter (1.5) im Flächenschwerpunkt des Empfangsgitters (1.7) angeordnet ist.

6.  Abtastkopf nach Anspruch 5, **dadurch gekennzeichnet, daß** das Sendegitter (1.5) vollständig vom Empfangsgitter (1.7) umgeben ist.

7.  Abtastkopf nach einem der Ansprüche 4-6, **dadurch gekennzeichnet, daß** die Form des Empfangsgitters (1.7) einer Ellipse angenähert ist, deren größerer Durchmesser senkrecht zur Meßrichtung (M) liegt.

**8.** Abtastkopf nach einem der Ansprüche 4 - 7, **dadurch gekennzeichnet, daß** dem Sendegitter (1.5) eine Lichtquelle (1.6) zugeordnet ist.

**9.** Abtastkopf nach einem der vorhergehenden Ansprüche, **dadurch gekennzeichnet, daß** benachbarte photoempfindliche Bereiche (3) um 180 Grad phasenverschobene Signale abgeben.

**10.** Abtastkopf nach Anspruch 9, **dadurch gekennzeichnet, daß** eine Teilungsperiode (T) des Empfangsgitters (1.7) der Hälfte einer Periode (P) eines einfallenden örtlich modulierten Intensitätsmusters (L) entspricht.

**11.** Abtastkopf nach einem der Ansprüche 1 - 8, **dadurch gekennzeichnet, daß** benachbarte photoempfindliche Bereiche (3) um 90 Grad phasenverschobene Signale abgeben.

**12.** Abtastkopf nach Anspruch 11, **dadurch gekennzeichnet, daß** eine Teilungsperiode (T) des Empfangsgitters (1.7) einem Viertel einer Periode (P) eines einfallenden örtlich modulierten Intensitätsmusters (L) entspricht.

**13.** Abtastkopf nach einem der vorhergehenden Ansprüche, **dadurch gekennzeichnet, daß** der Halbleiterschichtstapel (1.2) aus amorphem Silizium gebildet ist.

**14.** Abtastkopf nach einem der vorhergehenden Ansprüche, **dadurch gekennzeichnet, daß** eine Restdicke der i-Schicht (1.2.2) zwischen den photoempfindlichen Bereichen (3) geringer ist als eine Dicke der i-Schicht (1.2.2) in den photoempfindlichen Bereichen (3).

**15.** Abtastkopf nach einem der Ansprüche 14 - 16, **dadurch gekennzeichnet, daß** die Restdicke der i-Schicht (1.2.2) bei ca. 90% der Dicke der i-Schicht (1.2.2) liegt.

## Claims

**1.** Scanning head for optical position measuring systems, comprising a receiving grating (1.7) having photosensitive regions (3) for scanning locally and periodically intensity-modulated light of different phase angles, wherein the photosensitive regions are arranged such that they detect different phases of the intensity-modulated light and supply corresponding output signals, and wherein the receiving grating (1.7) has a semiconductor layer stack (1.2) composed of a doped p-type layer (1.2.1), an intrinsic i-type layer (1.2.2) and a doped n-type layer (1.2.3), **characterized in that** the photosensitive regions (3) share a first of the two doped layers (1.2.1) and at least part of the intrinsic layer (1.2.2) and are electrically isolated from one another by interruptions in a second of the two doped layers (1.2.3).

**2.** Scanning head according to Claim 1, **characterized in that** the semiconductor layer stack (1.2) is arranged on a transparent substrate (1.1) with a conductive, likewise transparent electrode (1.3), followed by rear-side contacts (1.4), thus resulting in a layer construction in accordance with

    - transparent substrate (1.1)
    - conductive electrode (1.3)
    - first doped layer or p-type layer (1.2.1)
    - intrinsic layer (1.2.2)
    - second doped layer or n-type layer (1.2.3)
    - rear-side contact (1.4).

**3.** Scanning head according to Claim 2, **characterized in that** the photosensitive regions (3) are defined by the rear-side contacts (1.4).

**4.** Scanning head according to Claim 2 or 3, **characterized in that** a transmitting grating (1.5) is arranged on the substrate (1.1).

**5.** Scanning head according to Claim 4, **characterized in that** the transmitting grating (1.5) is arranged at the area centroid of the receiving grating (1.7).

**6.** Scanning head according to Claim 5, **characterized in that** the transmitting grating (1.5) is completely surrounded by the receiving grating (1.7).

**7.** Scanning head according to any of Claims 4-6, **characterized in that** the shape of the receiving grating (1.7) is approximated to an ellipse, the larger diameter of which is perpendicular to the measuring direction (M).

**8.** Scanning head according to any of Claims 4-7, **characterized in that** a light source (1.6) is assigned to the transmitting grating (1.5).

**9.** Scanning head according to any of the preceding claims, **characterized in that** adjacent photosensitive regions (3) emit signals phase-shifted by 180 degrees.

**10.** Scanning head according to Claim 9, **characterized in that** a graduation period (T) of the receiving grating (1.7) corresponds to half of a period (P) of an incident locally modulated intensity pattern (L).

**11.** Scanning head according to any of Claims 1-8, **characterized in that** adjacent photosensitive regions (3) emit signals phase-shifted by 90 degrees.

**12.** Scanning head according to Claim 11, **characterized in that** a graduation period (T) of the receiving grating (1.7) corresponds to one quarter of a period (P) of an incident locally modulated intensity pattern (L).

**13.** Scanning head according to any of the preceding claims, **characterized in that** the semiconductor layer stack (1.2) is formed from amorphous silicon.

**14.** Scanning head according to any of the preceding claims, **characterized in that** a residual thickness of the i-type layer (1.2.2) between the photosensitive regions (3) is less than a thickness of the i-type layer (1.2.2) in the photosensitive regions (3).

**15.** Scanning head according to any of Claims 14-16, **characterized in that** the residual thickness of the i-type layer (1.2.2) is approximately 90% of the thickness of the i-type layer (1.2.2).


**Revendications**

**1.** Tête de balayage pour systèmes optiques de mesure de position, comprenant un réseau de réception (1.7) comportant des zones photosensibles (3) pour le balayage d'une lumière spatialement et périodiquement modulée en intensité ayant des positions de phase différentes, les zones photosensibles étant disposées de manière à détecter des phases différentes de la lumière modulée en intensité et à délivrer des signaux de sortie correspondants, et le réseau de réception (1.7) comprenant un empilement de couches semi-conductrices (1.2) constituées d'une couche dopée p (1.2.1), d'une couche intrinsèque i (1.2.2) et d'une couche dopée n (1.2.3), **caractérisée en ce que** les zones photosensibles (3) ont en commun les deux couches dopées (1.2.1) et au moins une partie de la couche intrinsèque (1.2.2) et **en ce qu'**elles sont séparées électriquement les unes des autres par des interruptions d'une seconde des deux couches dopées (1.2.3).

**2.** Tête de balayage selon la revendication 1, **caractérisée en ce que** l'empilement de couches semi-conductrices (1.2) est disposé sur un substrat transparent (1.1) comportant une électrode (1.3) conductrice, également transparente, suivie de contacts arrières (1.4), de telle sorte qu'il en résulte la structure de couches suivante :

- substrat transparent (1.1)
- électrode conductrice (1.3)
- première couche dopée ou couche p (1.2.1)
- couche intrinsèque (1.2.2)
- seconde couche dopée ou couche n (1.2.3)
- contact arrière (1.4).

**3.** Tête de balayage selon la revendication 2, **caractérisée en ce que** les zones photosensibles (3) sont définies par les contacts arrières (1.4).

**4.** Tête de balayage selon la revendication 2 ou 3, **caractérisée en ce qu'**un réseau d'émission (1.5) est disposé sur le substrat (1.1).

**5.** Tête de balayage selon la revendication 4, **caractérisée en ce que** le réseau d'émission (1.5) est disposé au centroïde du réseau de réception (1.7).

**6.** Tête de balayage selon la revendication 5, **caractérisée en ce que** le réseau d'émission (1.5) est entièrement entouré par le réseau de réception (1.7).

**7.** Tête de balayage selon l'une quelconque des revendications 4 à 6, **caractérisée en ce que** la forme du réseau de réception (1.7) est proche de celle d'une ellipse dont le grand axe est perpendiculaire à la direction de mesure (M).

**8.** Tête de balayage selon l'une quelconque des revendications 4 à 7, **caractérisée en ce qu'**une source de lumière (1.6) est associée au réseau d'émission (1.5).

**9.** Tête de balayage selon l'une quelconque des revendications précédentes, **caractérisée en ce que** des zones photosensibles voisines (3) produisent des signaux déphasés de 180°.

**10.** Tête de balayage selon la revendication 9, **caractérisée en ce qu'**une période de pas (T) du réseau de réception (1.7) correspond à la moitié d'une période (P) d'un motif d'intensité (L) incident modulé spatialement.

**11.** Tête de balayage selon l'une quelconque des revendications 1 à 8, **caractérisée en ce que** des zones photosensibles (3) voisines délivrent des signaux déphasés de 90°.

**12.** Tête de balayage selon la revendication 11, **caractérisée en ce qu'**une période de pas (T) du réseau de réception (1.7) correspond à un quart d'une période (P) d'un motif d'intensité (L) incident modulé spatialement.

**13.** Tête de balayage selon l'une quelconque des revendications précédentes, **caractérisée en ce que** l'empilement de couches semi-conductrices (1.2) est constitué de silicium amorphe.

**14.** Tête de balayage selon l'une quelconque des revendications précédentes, **caractérisée en ce qu'**une épaisseur restante de la couche i (1.2.2) est plus faible entre les zones photosensibles (3) qu'une épaisseur de la couche i (1.2.2) dans les zones photosensibles (3).

**15.** Tête de balayage selon l'une quelconque des revendications 14 à 16, **caractérisée en ce que** l'épaisseur restante de la couche i (1.2.2) est d'environ 90 % de l'épaisseur de la couche i (1.2.2).

FIG. 1a

EP 1 695 391 B1

FIG. 1b

FIG. 1c

FIG. 2a

FIG. 2b

FIG. 2c

FIG. 2d

1.5

2e

1

M

0°/180°   90°/270°   0°/180°   90°/270°

1.7

EP 1 695 391 B1

## FIG. 2e

0°    180°    270°    90°

1.5    M    4    1.7    4

## FIG. 3a

## FIG. 3b

FIG. 3c

FIG. 3d

270°

90°

3

1.7

0°

180°

5

4

# EP 1 695 391 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20020021450 A1
- GB 1269634 A
- DE 19961250 A1
- DE 10129334 A1